# EUROPEAN PATENT SPECIFICATION

(11) **EP 0 455 267 B1**
(45) Date of publication and mention of the grant of the patent: **01.05.1996**
(21) Application number: 91109882.0
(22) Date of filing: 30.01.1987
(51) Int. Cl.: G11B 20/14, G11B 20/12

(54) **Data demodulation system**
Datendemodulationssystem
Système de démodulation de données

(30) Priority: 31.01.1986 JP 20448/86
(43) Date of publication of application: 06.11.1991
(62) Divisional of application: 87300832.0
(73) Proprietor: SHARP KABUSHIKI KAISHA, Osaka 545 (JP)
(72) Inventor: Tsuji, Kentaroh, Nara-shi, Nara-ken (JP); Fujiwara., Tsuneo, Tenri-shi, Nara-ken (JP); Maeda, Shigemi, Yamatokoriyama-shi, Nara-ken (JP); Yamaguchi, Takeshi, Tenri-shi, Nara-ken (JP); Deguchi, Toshihisa, Daiya-Heights Gakuenmae C-722, Nara-shi, Nara-ken (JP); Kobayashi, Shozou, Nara-shi, Nara-ken (JP)
(74) Representative: Brown, Kenneth Richard

(56) References cited:
- WO-A-85/01402
- ELECTRONICS AND WIRELESS WORLD,vol. 91, no. 1591, May 1985, Sutton, Surrey, GB pages 27 - 28,J.R. WATKINSON:"Channel code and disc format"
- IEEE SPECTRUM,vol. 21, no. 3, March 1984, New York, US;pages 35 - 39;SENRI MIYAOKA:"Digital audio is compact and rugged"
- PATENT ABSTRACTS OF JAPAN vol. 8, no. 89 (P-270)(1526) 24 April 1984;& JP-A-59003714
- IBM TDB Vol. 27, No. 7b, Dec. 1984, pages 4274 to 4277

## Description

This invention relates to a data modulating/ demodulating method and apparatus used in magnetic recording, optical recording, etc.

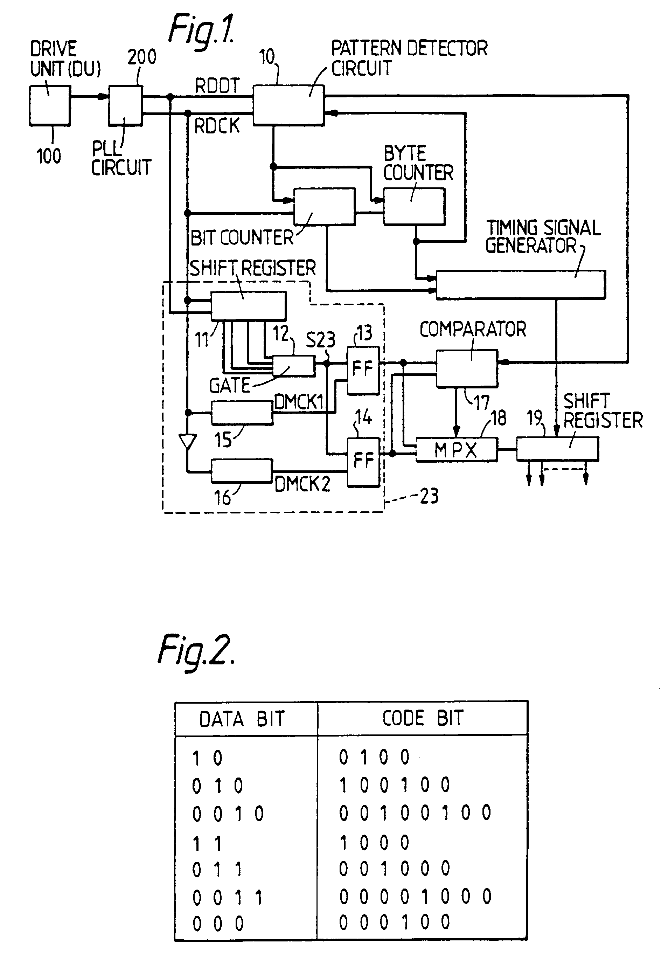

Conventionally, one known sequential coding method of constant ratio data codes of variable word length is the 2-7 modulation/demodulation system as described in United States Patent Specification No. 4115768 (the disclosure of which is included herein by way of reference) is known. In the 2-7 modulation/demodulation system, as shown in Fig. 2, 2-bit codes are used for 1-bit data, and when demodulating, in order to convert 2-bit codes into original 1-bit data, a demodulation clock DMCK is needed.

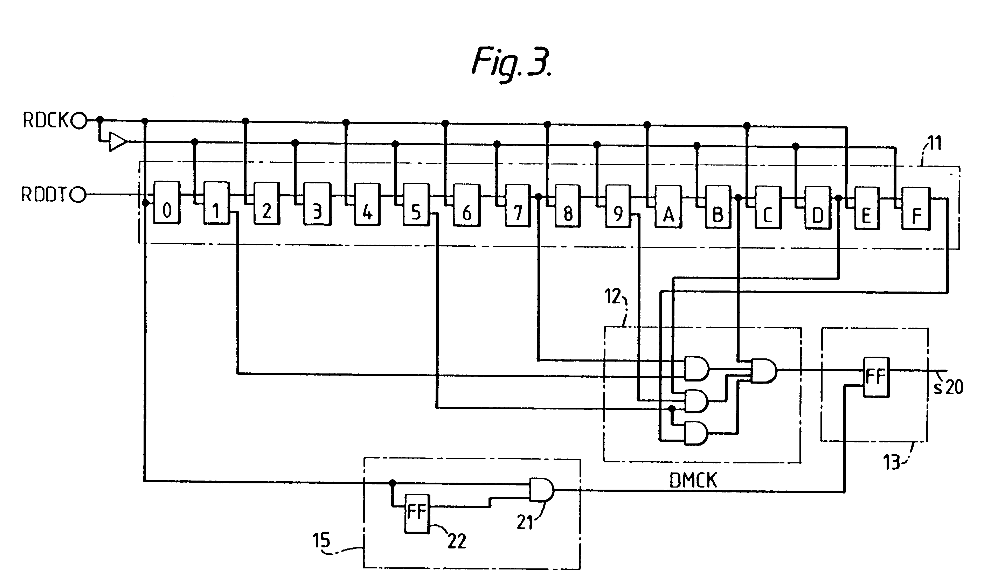

Fig. 3 refers to an example of a conventional demodulation circuit employed in the 2-7 modulation/ demodulation system. In this system the read data RDDT is introduced into a shift register 11 which is operated by a read clock RDCK. The output of the shift register 11 is introduced into a logic gate circuit 12, and this output is synchronized by a demodulation clock DMCK having 1/2 the period of read clock RDCK and introduced into a demodulation clock generator circuit 13, thereby obtaining demodulated data S20.

Thus, in the conventional circuit, since the demodulation clock DMCK is obtained by compressing the read clock RDCK to 1/2 period by flip-flop 22 and AND gate 21, if a wrong inversion occurs in the demodulation clock DMCK due to noise or some other cause, all the subsequent demodulated data S20 is wrong.

The invention claimed in European patent application 87300832.0 (now granted as European patent 0232144), from which this application is divided, related to the use of two mutually phase-shifted clock signals to provide respective demodulated versions of a predetermined signal pattern in each data block of a signal, these different versions being compared with a demodulation pattern known to be correct, so as to permit selection of the particular demodulating clock signal producing the correct result. In this way if an incorrect inversion occurs in the clock, normal operation can be quickly restored, so that error in the demodulated data is limited to one data block.

To enable this system of European patent 0232144 to operate securely, it is important to be able to detect accurately the beginning of each block. The present invention aims to provide a method and apparatus enabling such secure data block detection.

IBM TDB Vol. 27, No. 7B, December 1984, pages 4274 to 4277, IEEE Spectrum 21 (1984) Mar., No. 3, New York, USA, and Electronics and Wireless World, 91(1985) May, No. 1591, pages 27 and 28, disclose methods for providing a modulated signal and synchronisation pattern from data signal dividedly recorded in a plurality of recording blocks on a recording medium. The third of these documents discloses the addition of a specified data pattern to a data dividing portion of each recording block, and the second document dislcoses the modulation of each recording block and its specified data pattern to provide a respective coded signal portion separated from adjacent coded signal portions at coded dividing portions. Also, the first of these documents suggests adding a specified coded pattern which cannot be obtained from the coding of the data bits to the coded signal portion at a coded dividing portion.

According to the present invention, there is provided a data modulating/demodulating method for reproducing correct data which has been divided and recorded in a plurality of blocks on a recording medium, each of said plurality of blocks being separated from adjacent blocks at identifiably coded dividing portions characterised in that said method comprises, the steps of:
(a) adding a specified data pattern to each block at said dividing portion to enable modulation of the block;
(b) modulating each block and its specified data pattern to provide a respective coded signal portion separated from adjacent coded signal portions at coded dividing portions;
(c) adding a specified coded pattern to said coded signal portion at said coded dividing portion so as to form a coded signal for recording on said recording medium;
(d) demodulating said coded signal so as to reproduce said correct data in said plurality of blocks from said recording medium,
wherein as a result of said step (c) a combined coded pattern including a first coded pattern and a second coded pattern is obtained at each of said coded dividing portions, said first coded pattern corresponding to a pattern obtained by modulating said specified data pattern, said second pattern being said specified coded pattern, and wherein said combined coded pattern is a resynchronization pattern which is used to detect said dividing portions of said plurality of blocks.

According to the present invention, there is also provided a modulating/demodulating apparatus for reproducing correct data which has been divided and recorded in a plurality of blocks on a recording medium, each of said plurality of blocks being separated from adjacent blocks at identifiably coded dividing portions, characterised in that said apparatus comprises;
first adding means for adding a specified data pattern to each block at said dividing portion to enable a modulation of the block;
modulating means for modulating each block and its specified data pattern to provide a respective coded signal portion separated from adjacent coded signal portions at coded dividing portions;
second adding means for adding a specified coded pattern to said coded signal portion at said coded dividing portion so as to form a coded signal for recording on said recording medium;
demodulating means for demodulating said coded signal so as to reproduce said correct data in said plurality of blocks from said recording medium, wherein said second adding means is arranged so that a combined coded pattern including a first coded pattern and a second coded pattern is obtained at each of said coded dividing portions, said first coded pattern corresponding to a pattern obtained by modulating said specified data pattern, said second pattern being said specified coded pattern, and wherein said combined coded pattern is a resynchronization pattern which is used to detect said dividing portions of said plurality of blocks.

The present invention will be more fully understood from the detailed description given hereinbelow and the accompanying drawings which are given by way of illustration only, and thus are not limitative of the present invention and wherein:
Fig. 1 is a block diagram of a system configuration for performing the demodulation system according to this invention;
Fig. 2 is an explanatory diagram to show the coding type of the 2-7 modulation/demodulation system;
Fig. 3 is a circuit diagram of a conventional demodulation circuit;
Fig. 4 is an explanatory diagram of a recording format in recording medium; and
Fig. 5 and Fig. 6 are explanatory diagrams of bit patterns.

Referring now to the drawings, this invention is described herein in detail, specifically relating to some of its embodiments.

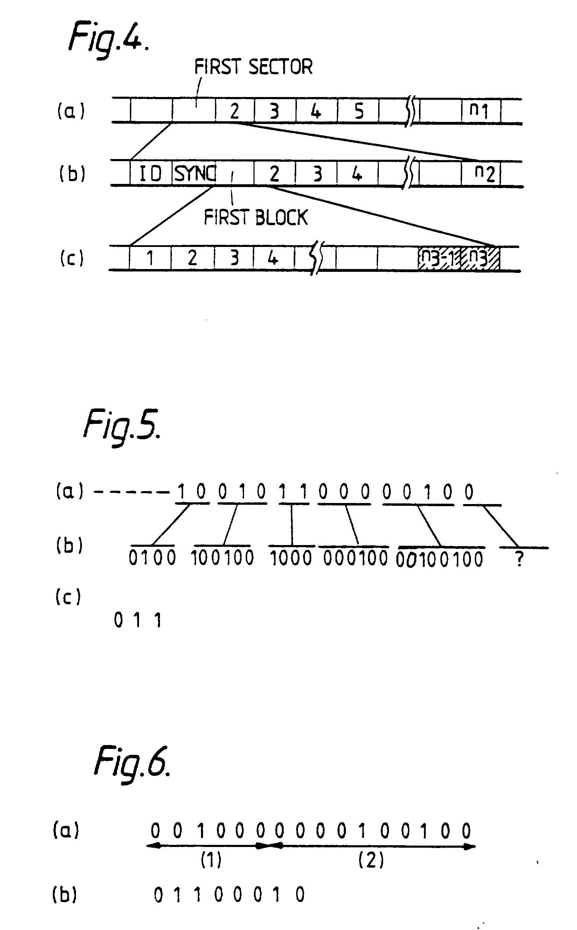

Fig. 4 shows an example of the recording format employed in magnetic recording, optical recording, etc. Fig. 1 is a block diagram of the system configuration for the demodulation system of this invention. The tracks on the recording medium are, for example, divided into n₁ sectors as shown in Fig. 4(a).

A drive unit (DU) 100 in Fig. 1 writes data in the units of these sectors. Each sector is composed of, a control signal area comprising ID, SYNC, etc., shown in Fig 4(b), and a user data recording area comprising n₂ blocks. Each block is composed of n₃ bytes as shown in Fig. 4(c). At the beginning or at the end of this block, a resynchronisation signal is added composed of a specified data bit pattern and a code bit pattern.

The above specified data bit pattern and code bit pattern are briefly described below.

The data bit pattern is a bit pattern before modulation. It comprises a row of consecutive data, for example a data row as shown in Fig. 5(a). When this bit pattern is 2-7 modulated, as shown in Fig. 5(b), as the word length of the 2-7 modulation/demodulation system is variable, a bit pattern that cannot be modulated using the 2-7 conversion rule may occur at the end of a data row or at the dividing portion of block. Accordingly, a specified data bit pattern is added in order to satisfy the 2-7 conversion rule to ensure that the entire data of a block or row can be modulated. One example of a suitable specified data bit pattern for application to the end of a data row or block is shown in Fig. 5(c).

The specified code bit pattern is a bit pattern after modulation. It is used in the detection of the beginning of a block during demodulating. In order to enhance the reliability of demodulation, a pattern not produced as a result of modulation using the 2-7 conversion code, such as the code bit pattern shown in Fig. 6(a) is preferable. Part (1) of the pattern of Fig. 6(a) is the same as the pattern after modulation of the specified data bit pattern shown in Fig. 5(c). By adding part (2) of Fig. 6(a) to this data row, a pattern which is not produced by modulation using the 2-7 conversion rule is obtained. When the pattern of Fig. 6(a) is demodulated, the result is always the pattern of Fig. 6(b).

In the system shown in Fig. 1, the data being read out by the drive unit (DU) 100 for recording and reproducing data is synchronised by a PLL circuit 200, from which read data RDDT and read clock RDCK are delivered. The RDDT and RDCK signals are fed into a pattern detector circuit 10 composed of a shift register, a pattern discriminator, and a 2-7 demodulation circuit 23. The pattern detector circuit 10 discriminates the RDDT, and detects the specified code bit pattern and SYNC pattern, and delivers a detection signal to the comparator 17. The RDDT fed into the 2-7 demodulation circuit 23 is converted into parallel by the shift register 11, and is assembled by a gate group 12 to be returned to serial data S23. The read clock RDCK is directly divided into RDCK and RDCK through NOT circuit 24, which are respectively fed into demodulation clock generator circuits 15, 16, to generate demodulation clock signals DMCK1, DMCK2. DMCK1 and DMCK2 are respectively fed into flip-flops (FF) 13, 14. In the flip-flops (FF) 13, 14, the serial data S23 is synchronised for conversion back into data before modulation. As the data is demodulated in the flip-flops (FF) 13, 14 by demodulation clocks DMCK1, DMCK2 differing in phase, the data output from the respective flip-flops (FF) is different. Only one of the outputs corresponds to the original data before modulation.

The outputs of the flip-flops (FF) 13, 14 are fed into a comparator 17, which receives the detection signal of a specified code bit pattern shown in Fig. 6(a) from the pattern detector circuit 10. The outputs of the flip-flops (FF) 13, 14 are compared with the bit pattern of Fig. 6(b) on receipt of the detection signal, and a judgement signal is delivered to a multiplexer (MPX) 18 depending on which output of the flip-flops (FF) 13, 14 corresponds to the bit pattern of Fig. 6(b). The multiplexer (MPX) 18 receives this judgement signal, and selects which output corresponds to the correctly demodulated data signal each time the signal of Fig. 6(a) is detected to ensure that a signal corresponding to the original data signal is delivered to the shift register 19.

The present system can thereby keep the spread of error in the demodulated data to a minimum when an incorrect inversion occurs in the read clock RDCK. Besides, as shown in Fig. 1, having two demodulation clock generator circuits 15, 16 and hence a normal demodulation clock DMCK1 and an inverted demodulation clock DMCK2, if an incorrect inversion occurs in the normal demodulation clock DMCK1, the next time the signal of Figure 6(a) is detected, the multiplexer (MPX) 17 selects the other demodulation clock DMCK2 for demodulation of the signal, so that any error in demodulation is limited to a single block, allowing normal demodulation of subsequent blocks.

As is clear from the description above, through the use of two demodulation clocks differing in phase, even if an incorrect inversion occurs in the read demodulation clock due to skipping, overflow or some other cause during the demodulation of any one block, normal operation is restored for demodulation of the next block. The reliability of the demodulated data is thereby enhanced. In order to operate securely, it is important to detect the beginning portion of a block. In this invention, by using a pattern not produced by modulation of a signal using the 2-7 conversion code, that is, by using a pattern which is not produced in the coded data, the beginning of a block can be detected without fail. Incidentally, the pattern of Fig. 6(a) may be also used as the bit pattern of SYNC information.

## Claims

1. A data modulating/demodulating method for reproducing correct data which has been divided and recorded in a plurality of blocks on a recording medium, each of said plurality of blocks being separated from adjacent blocks at identifiably coded dividing portions characterised in that said method comprises, the steps of:
(a) adding a specified data pattern to each block at said dividing portion to enable modulation of the block;
(b) modulating each block and its specified data pattern to provide a respective coded signal portion separated from adjacent coded signal portions at coded dividing portions;
(c) adding a specified coded pattern to said coded signal portion at said coded dividing portion so as to form a coded signal for recording on said recording medium;
(d) demodulating said coded signal so as to reproduce said correct data in said plurality of blocks from said recording medium,
wherein as a result of said step (c) a combined coded pattern including a first coded pattern and a second coded pattern is obtained at each of said coded dividing portions, said first coded pattern corresponding to a pattern obtained by modulating said specified data pattern, said second pattern being said specified coded pattern, and wherein said combined coded pattern is a resynchronization pattern which is used to detect said dividing portions of said plurality of blocks.

2. A method according to claim 1, wherein said specified data pattern is configured to enable a data signal obtained by adding said specified data pattern to a block to be modulated.

3. A method according to claim 2, wherein said data signal satisfies a 2-7 conversion rule.

4. A method according to any preceding claim, wherein said specified data pattern is added to the end of each block.

5. A method according to any preceding claim, wherein said specified data pattern is "011".

6. A method according to any preceding claim, wherein said step (b) modulates each block and its specified data pattern according to the following table:
| Data Bits | Code Bits |
|---|---|
| 10 | 0100 |
| 010 | 100100 |
| 0010 | 00100100 |
| 11 | 1000 |
| 011 | 001000 |
| 0011 | 00001000 |
| 000 | 000100. |

7. A method according to any preceding claim, wherein said specified coded pattern is configured to enable detection of said dividing portions of said plurality of blocks for resynchronization.

8. A method according to any preceding claim, wherein said specified coded pattern is added to the end of each coded signal portion.

9. A method according to any preceding claim, wherein said specified coded pattern is "0000100100".

10. A method according to claim 1, wherein said combined coded pattern is one which cannot be produced by 2-7 conversion.

11. A modulating/demodulating apparatus for reproducing correct data which has been divided and recorded in a plurality of blocks on a recording medium, each of said plurality of blocks being separated from adjacent blocks at identifiably coded dividing portions, characterised in that said apparatus comprises;
first adding means for adding a specified data pattern to each block at said dividing portion to enable a modulation of the block;
modulating means for modulating each block and its specified data pattern to provide a respective coded signal portion separated from adjacent coded signal portions at coded dividing portions;
second adding means for adding a specified coded pattern to said coded signal portion at said coded dividing portion so as to form a coded signal for recording on said recording medium;
demodulating means for demodulating said coded signal so as to reproduce said correct data in said plurality of blocks from said recording medium, wherein said second adding means is arranged so that a combined coded pattern including a first coded pattern and a second coded pattern is obtained at each of said coded dividing portions, said first coded pattern corresponding to a pattern obtained by modulating said specified data pattern, said second pattern being said specified coded pattern, and wherein said combined coded pattern is a resynchronization pattern which is used to detect said dividing portions of said plurality of blocks.

12. An apparatus according to claim 11, wherein said specified data pattern is configured to enable a data signal obtained by adding said specified data pattern to a block to be modulated.

13. An apparatus according to claim 12, wherein said data signal satisfies a 2-7 conversion rule.

14. An apparatus according to any of claims 11 to 13, wherein said first adding means is arranged to add said specified data pattern to the end of each block.

15. An apparatus according to any of claims 11 to 14, wherein said specified data pattern is "011".

16. An apparatus according to any of claims 11 to 15, wherein said modulating means is arranged to modulate each block and its specified data pattern according to the following table:
| Data Bits | Code Bits |
|---|---|
| 10 | 0100 |
| 010 | 100100 |
| 0010 | 00100100 |
| 11 | 1000 |
| 011 | 001000 |
| 0011 | 00001000 |
| 000 | 000100. |

17. An apparatus according to any of claims 11 to 16, wherein said specified coded pattern is configured to enable detection of said dividing portions of said plurality of blocks for resynchronization.

18. An apparatus according to any of claims 11 to 17, wherein said second adding means is arranged to add said specified coded pattern to the end of each coded signal portion.

19. An apparatus according to any of claims 11 to 18, wherein said specified coded pattern is "0000100100".

20. An apparatus according to any of claims 11 to 19, wherein said combined coded pattern is one which cannot be produced by 2-7 conversion.

## Patentansprüche

1. Daten-Modulations/Demodulations-Verfahren zum Wiedergeben korrekter Daten, die aufgeteilt und in mehreren Blöcken auf einem Aufzeichnungsmedium aufgezeichnet wurden, wobei jeder der mehreren Blöcke von benachbarten Blöcken an erkennbar codierten Unterteilungsabschnitten getrennt ist, **dadurch gekennzeichnet,** daß das Verfahren die folgenden Schritte umfaßt:
(a) Hinzufügen eines speziellen Datenmusters zu jedem Block am Unterteilungsabschnitt, um eine Modulation des Blocks zu ermöglichen;
(b) Modulieren jedes Blocks und seines speziellen Datenmusters, um einen jeweiligen codierten Signalabschnitt zu erzeugen, der von benachbarten codierten Signalabschnitten an codierten Unterteilungsabschnitten getrennt ist;
(c) Hinzufügen eines speziellen Codemusters zum codierten Signalabschnitt am codierten Unterteilungsabschnitt, um ein codiertes Signal für den Aufzeichnungsvorgang auf dem Aufzeichnungsmedium zu erzeugen;
(d) Demodulieren des codierten Signals, um die korrekten Daten in den mehreren Blöcken vom Aufzeichnungsmedium wiederzugeben;
- wobei als Ergebnis des Schritts (c) ein kombiniertes Codemuster mit einem ersten Codemuster und einem zweiten Codemuster an jedem der codierten Unterteilungsabschnitte erhalten wird, wobei das erste Codemuster einem Muster entspricht, das dadurch erhalten wird, daß das spezielle Datenmuster moduliert wird, und wobei das zweite Muster das spezielle Codemuster ist, und wobei das kombinierte Codemuster ein Neusynchronisiermuster ist, das dazu verwendet wird, die Unterteilungsabschnitte der mehreren Blöcke zu erkennen.

2. Verfahren nach Anspruch 1, bei dem das spezielle Datenmuster so beschaffen ist, daß es die Modulation eines Datensignals ermöglicht, das dadurch erhalten wird, daß das spezielle Datenmuster zu einem Block hinzugefügt wird.

3. Verfahren nach Anspruch 2, bei dem das Datensignal der 2-7-Umsetzungsregel genügt.

4. Verfahren nach einem der vorstehenden Ansprüche, bei dem das spezielle Datenmuster an das Ende jedes Blocks hinzugefügt wird.

5. Verfahren nach einem der vorstehenden Ansprüche, bei dem das spezielle Datenmuster das Muster "011" ist.

6. Verfahren nach einem der vorstehenden Ansprüche, bei dem im Schritt (b) jeder Block und sein spezielles Datenmuster gemäß der folgenden Tabelle moduliert wird:
| Datenbits | Codebits |
|---|---|
| 10 | 0100 |
| 010 | 100100 |
| 0010 | 00100100 |
| 11 | 1000 |
| 011 | 001000 |
| 0011 | 00001000 |
| 000 | 000100. |

7. Verfahren nach einem der vorstehenden Ansprüche, bei dem das spezielle Codemuster so beschaffen ist, daß es die Erkennung der Unterteilungsabschnitte der mehreren Blöcke für Neusynchronisierung ermöglicht.

8. Verfahren nach einem der vorstehenden Ansprüche, bei dem das spezielle Codemuster an das Ende jedes codierten Signalabschnitts hinzugefügt wird.

9. Verfahren nach einem der vorstehenden Ansprüche, bei dem das spezielle Codemuster das Muster "0000100100" ist.

10. Verfahren nach Anspruch 1, bei dem das kombinierte Codemuster ein solches ist, das durch 2-7-Umsetzung nicht erzeugt werden kann.

11. Daten-Modulations/Demodulations-Vorrichtung zum Wiedergeben korrekter Daten, die aufgeteilt und in mehreren Blökken auf einem Aufzeichnungsmedium aufgezeichnet wurden, wobei jeder der mehreren Blöcke von benachbarten Blöcken an erkennbar codierten Unterteilungsabschnitten getrennt ist, **dadurch gekennzeichnet,** daß das Vorrichtung folgendens aufweist:
- eine Addiereinrichtung zum Addieren eines speziellen Datenmusters zu jedem Block am Unterteilungsabschnitt, um eine Modulation des Blocks zu ermöglichen;
- eine Modulationseinrichtung zum Modulieren jedes Blocks und seines speziellen Datenmusters, um einen jeweiligen codierten Signalabschnitt zu erzeugen, der von benachbarten codierten Signalabschnitten an codierten Unterteilungsabschnitten getrennt ist;
- eine zweite Addiereinrichtung zum Addieren eines speziellen Codemusters zum codierten Signalabschnitt am codierten Unterteilungsabschnitt, um ein codiertes Signal für den Aufzeichnungsvorgang auf dem Aufzeichnungsmedium zu erzeugen;
- eine Demodulationseinrichtung zum Demodulieren des codierten Signals, um die korrekten Daten in den mehreren Blöcken vom Aufzeichnungsmedium wiederzugeben;
- wobei die zweite Addiereinrichtung so ausgebildet ist, daß ein kombiniertes Codemuster mit einem ersten Codemuster und einem zweiten Codemuster an jedem der codierten Unterteilungsabschnitte erhalten wird, wobei das erste Codemuster einem Muster entspricht, das dadurch erhalten wird, daß das spezielle Datenmuster moduliert wird, und wobei das zweite Muster das spezielle Codemuster ist, und wobei das kombinierte Codemuster ein Neusynchronisiermuster ist, das dazu verwendet wird, die Unterteilungsabschnitte der mehreren Blöcke zu erkennen.

12. Vorrichtung nach Anspruch 11, bei der das spezielle Datenmuster so beschaffen ist, daß es die Modulation eines Datensignals ermöglicht, das dadurch erhalten wird, daß das spezielle Datenmuster zu einem Block hinzugefügt wird.

13. Vorrichtung nach Anspruch 12, bei der das Datensignal der 2-7-Umsetzungsregel genügt.

14. Vorrichtung nach einem der Ansprüche 11 bis 13, bei der die erste Addiereinrichtung so ausgebildet ist, daß sie das spezielle Datenmuster an das Ende jedes Blocks hinzufügt.

15. Vorrichtung nach einem der Ansprüche 11 bis 14, bei der das spezielle Datenmuster das Muster "011" ist.

16. Vorrichtung nach einem der Ansprüche 11 bis 15, bei der die Modulationseinrichtung so ausgebildet ist, daß sie jeden Block und dessen spezielles Datenmuster gemäß der folgenden Tabelle moduliert:
| Datenbits | Codebits |
|---|---|
| 10 | 0100 |
| 010 | 100100 |
| 0010 | 00100100 |
| 11 | 1000 |
| 011 | 001000 |
| 0011 | 00001000 |
| 000 | 000100. |

17. Vorrichtung nach einem der Ansprüche 11 bis 16, bei der das spezielle Codemuster so beschaffen ist, daß es die Erkennung der Unterteilungsabschnitte der mehreren Blöcke für Neusynchronisierung ermöglicht.

18. Vorrichtung nach einem der Ansprüche 11 bis 17, bei der die zweite Addiereinrichtung so ausgebildet ist, daß sie das spezielle Codemuster an das Ende jedes codierten Signalabschnitts hinzufügt.

19. Vorrichtung nach einem der Ansprüche 11 bis 18, bei der das spezielle Codemuster das Muster "0000100100" ist.

20. Vorrichtung nach einem der Ansprüche 11 bis 19, bei der das kombinierte Codemuster ein solches ist, das durch 2-7-Umsetzung nicht erzeugt werden kann.

## Revendications

1. Procédé de modulation/démodulation de données pour reproduire des données correctes qui ont été divisées et enregistrées dans une pluralité de blocs sur un support d'enregistrement, chaque bloc de ladite pluralité de blocs étant séparé par rapport à des blocs adjacents au niveau de parties de division codées de façon identifiable, caractérisé en ce que ledit procédé comprend les étapes consistant à:
(a) ajouter un motif de données spécifié à chaque bloc au niveau de ladite partie de division afin d'autoriser une modulation du bloc;
(b) moduler chaque bloc et son motif de données spécifié pour fournir une partie de signal codée respective séparée par rapport à des parties de signal codées adjacentes au niveau de parties de division codées;
(c) ajouter un motif codé spécifié à ladite partie de signal codée au niveau de ladite partie de division codée afin de former un signal codé pour un enregistrement sur ledit support d'enregistrement;
(d) démoduler ledit signal codé afin de reproduire lesdites données correctes dans ladite pluralité de blocs provenant dudit support d'enregistrement,
dans lequel, consécutivement à ladite étape (c), un motif codé composé incluant un premier motif codé et un second motif codé est obtenu au niveau de chacune desdites parties de division codées, ledit premier motif codé correspondant à un motif obtenu en modulant ledit motif de données spécifié, ledit second motif étant ledit motif codé spécifié, et dans lequel ledit motif codé composé est un motif de resynchronisation qui est utilisé pour détecter lesdites portions de ladite pluralité de blocs.

2. Procédé selon la revendication 1, dans lequel ledit motif de données spécifié est configuré pour autoriser un signal de données obtenu en ajoutant ledit motif de données spécifié à un bloc à moduler.

3. Procédé selon la revendication 2, dans lequel ledit signal de données satisfait à une règle de conversion 2-7.

4. Procédé selon l'une quelconque des revendications précédentes, dans lequel ledit motif de données spécifié est ajouté à la fin de chaque bloc.

5. Procédé selon l'une quelconque des revendications précédentes, dans lequel ledit motif de données spécifié est "011".

6. Procédé selon l'une quelconque des revendications précédentes, dans lequel ladite étape (b) module chaque bloc et son motif de données spécifié conformément au tableau suivant:
| Bits de Données | Bits de Code |
|---|---|
| 10 | 0100 |
| 010 | 100100 |
| 0010 | 00100100 |
| 11 | 1000 |
| 011 | 001000 |
| 0011 | 00001000 |
| 000 | 000100. |

7. Procédé selon l'une quelconque des revendications précédentes, dans lequel ledit motif codé spécifié est configuré pour autoriser la détection desdites parties de division de ladite pluralité de blocs pour une resynchronisation.

8. Procédé selon l'une quelconque des revendications précédentes, dans lequel ledit motif codé spécifié est ajouté à la fin de chaque partie de signal codée.

9. Procédé selon l'une quelconque des revendications précédentes, dans lequel ledit motif codé spécifié est "0000100100".

10. Procédé selon la revendication 1, dans lequel ledit motif codé composé est un motif qui ne peut pas être produit par une conversion 2-7.

11. Dispositif de modulation/démodulation pour reproduire des données correctes qui ont été divisées et enregistrées dans une pluralité de blocs sur un support d'enregistrement, chaque bloc de ladite pluralité de blocs étant séparé par rapport à des blocs adjacents au niveau de parties de division codées de façon identifiable, caractérisé en ce que ledit dispositif comprend:
des premiers moyens d'addition pour ajouter un motif de données spécifié à chaque bloc au niveau de ladite partie de division afin d'autoriser une modulation du bloc;
des moyens de modulation pour moduler chaque bloc et son motif de données spécifié afin de fournir une partie de signal codée respective séparée par rapport à des parties de signal codées adjacentes au niveau de parties de division codées;
des seconds moyens d'addition pour ajouter un motif codé spécifié à ladite partie de signal codée au niveau de ladite partie de division codée afin de former un signal codé pour un enregistrement sur ledit support d'enregistrement;
des moyens de démodulation pour démoduler ledit signal codé afin de reproduire lesdites données correctes dans ladite pluralité de blocs provenant dudit support d'enregistrement,
dans lequel lesdits seconds moyens d'addition sont prévus de sorte qu'un motif codé composé incluant un premier motif codé et un second motif codé est obtenu au niveau de chacune desdites parties de division codées, ledit premier motif codé correspondant à un motif obtenu en modulant ledit motif de données spécifié, ledit second motif étant ledit motif codé spécifié, et dans lequel ledit motif codé composé est un motif de resynchronisation qui est utilisé pour détecter lesdites parties de division de ladite pluralité de blocs.

12. Dispositif selon la revendication 11, dans lequel ledit motif de données spécifié est configuré pour autoriser un signal de données obtenu en ajoutant ledit motif de données spécifié à un bloc à moduler.

13. Dispositif selon la revendication 12, dans lequel ledit signal de données satisfait à une règle de conversion 2-7.

14. Dispositif selon l'une quelconque des revendications 11 à 13, dans lequel lesdits premiers moyens d'addition sont prévus pour ajouter ledit motif de données spécifié à la fin de chaque bloc.

15. Dispositif selon l'une quelconque des revendications 11 à 14, dans lequel ledit motif de données spécifié est "011".

16. Dispositif selon l'une quelconque des revendications 11 à 15, dans lequel lesdits moyens de modulation sont prévus pour moduler chaque bloc et son motif de données spécifié conformément au tableau suivant:
| Bits de Données | Bits de Code |
|---|---|
| 10 | 0100 |
| 010 | 100100 |
| 0010 | 00100100 |
| 11 | 1000 |
| 011 | 001000 |
| 0011 | 00001000 |
| 000 | 000100. |

17. Dispositif selon l'une quelconque des revendications 11 à 16, dans lequel ledit motif codé spécifié est configuré pour autoriser la détection desdites parties de division de ladite pluralité de blocs pour une resynchronisation.

18. Dispositif selon l'une quelconque des revendications 11 à 17, dans lequel lesdits seconds moyens d'addition sont prévus pour ajouter ledit motif codé spécifié à la fin de chaque partie de signal codée.

19. Dispositif selon l'une quelconque des revendications 11 à 18, dans lequel ledit motif codé spécifié est "0000100100".

20. Dispositif selon l'une quelconque des revendications 11 à 19, dans lequel ledit motif codé composé est un motif qui ne peut pas être produit par une conversion 2-7.
